# DEMANDE DE BREVET EUROPEEN

(11) **EP 0 849 742 A1**
(43) Date de publication de la demande: **24.06.1998**
(21) Numéro de dépôt: 97410140.4
(22) Date de dépôt: 12.12.1997
(51) Int. Cl.: G11C 11/56

(54) **Cellule mémoire à quatre états**

(30) Priorité: 13.12.1996 FR 9615606
(71) Demandeur: SGS-THOMSON MICROELECTRONICS S.A., 94250 Gentilly (FR)
(72) Inventeur: Papadas, Constantin, 38610 Gières (FR); Guillaumot, Bernard, 38120 Le Fontanil (FR)
(74) Mandataire: de Beaumont, Michel

(57) **Abrégé**

L'invention concerne une cellule mémoire électriquement programmable à quatre états comprenant au-dessus d'une région de canal d'un premier type de conductivité une grille de commande isolée (24), des régions de source (30) et de drain (31) du deuxième type de conductivité, chacune de ces régions de source et de drain comprenant au voisinage du canal une zone à faible niveau de dopage (26, 27), une grille flottante (29, 28) recouvrant au moins en partie chacune desdites zones à faible niveau de dopage, l'épaisseur d'isolant sous chacune des grilles flottantes étant inférieure à l'épaisseur d'isolant sous la grille de commande et étant suffisamment faible pour qu'une injection de charges puisse se produire par effet tunnel.

## Description

La présente invention concerne les circuits de mémoire et plus particulièrement la réalisation d'une mémoire électriquement programmable à quatre états.

De façon classique, les mémoires électriquement programmables et électriquement effaçables, dites EEPROM, ont une structure de type transistor MOS à double grille, l'une des grilles ou grille de commande étant connectée à une borne extérieure et l'autre grille étant flottante, c'est-à-dire non connectée à une borne extérieure.

Il est connu que, en appliquant des tensions convenables aux bornes de drain, de source, de substrat et de commande d'une cellule EEPROM, il est possible d'injecter des charges dans la grille flottante ou de vider cette grille flottante de ces charges. L'injection de charges dans la grille flottante se fait, selon les dispositifs par porteurs chauds ou par effet tunnel.

Pour lire une telle cellule EEPROM, on applique des tensions convenables à la grille de commande, au drain et à la source et on mesure le courant drain-source. Ce courant aura des valeurs différentes selon l'état de la grille flottante. On peut donc différencier deux états ; c'est ce qui correspond à l'effet de mémoire. Normalement, pour assurer une mémorisation de quatre états, il est nécessaire d'utiliser deux cellules mémoire du type décrit ci-dessus.

On a également envisagé, notamment avec les cellules dans lesquelles la charge de la grille flottante se fait par effet tunnel, d'appliquer des charges plus ou moins importantes à la grille flottante pour différencier ainsi plusieurs états. Toutefois, la mise en oeuvre de tels procédés est particulièrement délicate si l'on veut avoir des seuils de détection relativement marqués.

Ainsi, un objet de la présente invention est de prévoir une cellule mémoire à quatre états dont les seuils de lecture puissent simplement être nettement différenciés et qui n'occupe pas une surface de silicium plus importante qu'une cellule mémoire classique.

Pour atteindre ces objets, la présente invention prévoit l'utilisation d'une cellule mémoire à double grille flottante comme cellule à quatre états, les grilles flottantes étant disposées de part et d'autre d'une grille de commande, l'épaisseur de l'isolant sous les grilles flottantes étant suffisamment faible pour que la charge/décharge des grilles flottantes se fasse par effet tunnel, dans laquelle chacun des états correspond à un état particulier de charge/décharge des deux grilles flottantes.

La présente invention prévoit aussi une cellule mémoire électriquement programmable à quatre états comprenant au-dessus d'une région de canal d'un premier type de conductivité une grille de commande isolée, des régions de source et de drain du deuxième type de conductivité, chacune de ces régions de source et de drain comprenant au voisinage du canal une zone à faible niveau de dopage, une grille flottante recouvrant au moins en partie chacune desdites zones à faible niveau de dopage, l'épaisseur d'isolant sous chacune des grilles flottantes étant inférieure à l'épaisseur d'isolant sous la grille de commande et étant suffisamment faible pour qu'une injection de charges puisse se produire par effet tunnel.

Selon un mode de réalisation de la présente invention, la cellule mémoire est associée à des moyens de programmation destinés à appliquer des tensions de source, de drain, de grille et de substrat pour charger ou décharger indépendamment chacune des grilles flottantes.

Selon un mode de réalisation de la présente invention, la cellule mémoire est associée à des moyens de lecture destinés à appliquer des tensions de source, de grille et de drain et à comparer le courant drain-source obtenu à des niveaux de seuil, pour déterminer un état de la cellule parmi quatre possibles.

Ces objets, caractéristiques et avantages, ainsi que d'autres de la présente invention seront exposés en détail dans la description suivante de modes de réalisation particuliers faite à titre non-limitatif en relation avec les figures jointes 1A à 1D qui reproduisent les figures 3A à 3D de la demande de brevet européen EP-A-0675547 de la demanderesse. Pour une description approfondie de ces figures, on se reportera à cette demande de brevet.

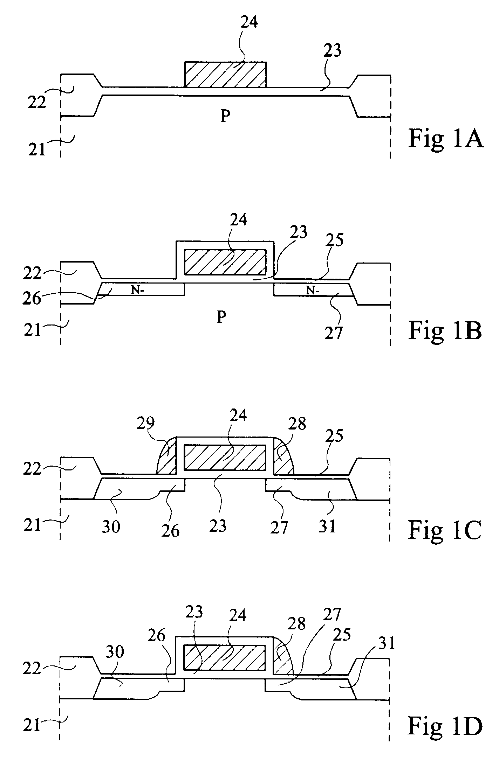

Si l'on considère plus particulièrement la figure 1C, celle-ci représente une structure de transistor à grille flottante comprenant, dans une zone délimitée par un oxyde épais 22, des régions de source et de drain 30 et 31, d'extension de source et d'extension de drain 26 et 27, de grille de commande 24, et d'espaceurs 29 et 28 en un matériau conducteur (du silicium polycristallin dopé) disposés au-dessus des régions d'extension de drain et de source, respectivement.

Dans la demande de brevet susmentionnée, la structure représentée en figure 1C ne constitue qu'une étape intermédiaire de fabrication d'un dispositif final illustré en figure 1D dans lequel l'un des espaceurs (29) est éliminé. Ceci avait pour but de réaliser une cellule EEPROM de dimension minimale dont l'espaceur 28 constitue la grille flottante. Dans cette cellule, l'épaisseur de l'isolant 25 sous la grille flottante est nettement inférieure à l'épaisseur de l'isolant 23 sous la grille de commande de sorte que la charge ou la décharge de la grille flottante 28 se fait par effet tunnel. Les avantages de cette structure sont exposés dans la demande de brevet susmentionnée.

La présente invention propose d'utiliser la structure illustrée en figure 1C pour réaliser une mémoire à quatre états, les espaceurs 28 et 29 étant utilisés comme grilles flottantes. Plus particulièrement, la grille flottante 28 peut être chargée ou déchargée en appliquant des tensions convenables à la source, au drain, au substrat et à la grille de commande. La présente invention prévoit de charger ou non la grille flottante 29 en appliquant le même procédé que celui décrit en relation avec la grille flottante 28 mais en inversant le rôle de la source et du drain.

Plus généralement, la présente invention s'applique à toute structure à grille flottante dans laquelle la grille flottante est constituée d'espaceurs réalisés symétriquement.

Toutefois, les inventeurs préfèrent appliquer l'idée générale de l'invention à une structure telle que celle illustrée en figure 1C et décrite dans la demande de brevet susmentionnée, à savoir dans laquelle la charge ou la décharge des grilles flottantes se fait par effet tunnel et dans laquelle les grilles flottantes correspondent à des espaceurs disposés au-dessus de régions d'extension de source et de drain.

En effet, dans cette cellule, les quatre états sont très bien définis car les deux états intermédiaires dans lesquels une seule grille flottante est chargée sont nettement différenciés. En effet, la grille flottante du côté de la source module la tension de seuil, alors que la grille flottante du côté du drain module la résistance mise en série avec le canal du côté du drain.

Un intérêt de cette cellule, par rapport à une cellule dans laquelle la charge/décharge se fait par porteurs chauds et où les grilles flottantes se trouvent au-dessus d'une portion de canal, est que, lors de la programmation de l'une des grilles flottantes par effet tunnel Fowler-Nordheim, l'état de la grille flottante symétrique n'est pas modifié. Par contre, dans le cas de grilles flottantes contrôlant une partie du canal, pendant la programmation de la grille flottante du côté du drain, la grille flottante du côté de la source verrait son état électrostatique modifié par le champ électrique latéral généré par l'effet espaceur du diélectrique entre la grille de commande et la grille flottante.

## Revendications

1. Utilisation d'une cellule mémoire à double grille flottante comme cellule à quatre états, les grilles flottantes étant disposées de part et d'autre d'une grille de commande, l'épaisseur de l'isolant sous les grilles flottantes étant suffisamment faible pour que la charge/décharge des grilles flottantes se fasse par effet tunnel, dans laquelle chacun des états correspond à un état particulier de charge/décharge de chacune des deux grilles flottantes.

2. Cellule mémoire électriquement programmable à quatre états comprenant au-dessus d'une région de canal d'un premier type de conductivité une grille de commande isolée (24), des régions de source (30) et de drain (31) du deuxième type de conductivité, chacune de ces régions de source et de drain comprenant au voisinage du canal une zone à faible niveau de dopage (26, 27), une grille flottante (29, 28) recouvrant au moins en partie chacune desdites zones à faible niveau de dopage, l'épaisseur d'isolant sous chacune des grilles flottantes étant inférieure à l'épaisseur d'isolant sous la grille de commande et étant suffisamment faible pour qu'une injection de charges puisse se produire par effet tunnel, caractérisée en ce qu'elle est associée à des moyens de programmation destinés à appliquer des tensions de source, de drain, de grille et de substrat pour charger ou décharger indépendamment chacune des grilles flottantes.

3. Cellule mémoire selon la revendication 2, caractérisée en ce qu'elle est associée à des moyens de lecture destinés à appliquer des tensions de source, de grille et de drain et à comparer le courant drain-source obtenu à des niveaux de seuil, pour déterminer un état de la cellule parmi quatre possibles.
